# EUROPEAN PATENT SPECIFICATION

(11) **EP 0 579 314 B1**
(45) Date of publication and mention of the grant of the patent: **29.04.1998**
(21) Application number: 93201982.1
(22) Date of filing: 07.07.1993
(51) Int. Cl.: H03K 19/0185, H03K 19/003, H04L 25/08

(54) **System comprising an output buffer circuit and an input buffer circuit**
System aus einer Ausgangs- und einer Eingangspufferschaltung
Ensemble constitué par des circuits tampons d'entrée et de sortie

(30) Priority: 14.07.1992 EP 92202152
(43) Date of publication of application: 19.01.1994
(73) Proprietor: Philips Electronics N.V., 5621 BA Eindhoven (NL)
(72) Inventor: Janssen, Daniel Johannes Gerardus, NL-5656 AA Eindhoven (NL)

(56) References cited:
- DE-A- 2 346 966
- DE-A- 2 929 450
- PATENT ABSTRACTS OF JAPAN vol. 012, no. 268 (E-638)27 July 1988 & JP-A-63 050 209 ( MATSUSHITA ELECTRIC IND CO LTD ) 3 March 1988
- PATENT ABSTRACTS OF JAPAN vol. 016, no. 367 (E-1245)7 August 1992 & JP-A-4 117 716 ( MITSUBISHI ELECTRIC CORP ) 17 April 1992

## Description

The invention relates to a buffer circuit, more specifically, an output buffer circuit comprising a first inverter circuit with an input terminal and an output terminal which also form the input terminal and the output terminal of the buffer circuit, and with terminals for a first supply voltage, there being inserted between the input terminal and the output terminal of the buffer circuit a series combination of a second inverter circuit and a first capacitor which second inverter circuit is connected to terminals for a second supply voltage.

Preferably, symmetrical first and second supply voltages are used and the first inverter circuit comprises at least a complementary pair of field effect transistors whose gate and drain connections are mutually coupled, in which the input terminal is coupled to the mutually coupled gate connections and the output terminal is coupled to the mutually coupled drain connections, in which the source connection of the p-channel FET of the complementary pair is coupled to the terminal for the first positive supply voltage and the source connection of the n-channel FET of the pair is coupled to the terminal for the first negative supply voltage.

A buffer circuit of this type is known from DE-A-2929450 in the form of a level shifter. This known circuit has for its object to convert an input voltage level into another, higher output voltage level while the output of the circuit comprising C-MOSFET's is capable of rapidly following voltage changes on the input. In order to increase the edge steepness of the output voltage, an inverter connected to the input terminal is provided, whose output terminal is connected to the output terminal of the buffer circuit *via* a capacitor combined in series with the output terminal. The inverter is coupled, on one side, to the positive supply voltage terminal and, on the other side, to a connection for a negative supply voltage which is less negative than the negative supply voltage for the complementary pair of FET's. As a result of these measures the combination of the inverter and the capacitor, which forms a differentiator, transfers very rapidly input voltage variations with a limited voltage swing to the output of the circuit, while the final output voltage level is reached in a conventional manner when one of the FET's conducts in an, of necessity, slightly delayed manner. The switch delay occurring in a thus structured circuit of C-MOSFET's is distinctly smaller than in a circuit comprising exclusively C-MOSFETS.

A disadvantage of the prior art circuit is that the voltage swing at the output is determined, on one hand, by the positive voltage level and, on the other hand, by the most negative voltage level so that, as a result of the high peak currents flowing through the supply lines during voltage transitions, annoying disturbing signals occur everywhere in the circuit that comprises the buffer circuit.

It is an object of the invention to provide a buffer circuit and, more specifically, a system comprising an input buffer circuit and an associated output buffer circuit, in which the problem of the occurrence of disturbing signals due to the high peak currents is largely suppressed, whereas the voltage transitions in the input signal can nevertheless be rapidly followed by the output.

According to a first aspect of the invention, the invention thereto provides a buffer circuit of said type, characterised in that the voltage swing of the output signal on the output terminal of the buffer circuit is a predetermined fraction of the voltage swing of the signal applied to the input terminal and in that determining means are provided for determining a reference voltage level as a further output signal, said determining means receiving the first supply voltage.

The invention is based on the recognition that the problems occurring due to the high peak currents during the change of the output voltage level may largely be suppressed, on one hand, by determining the output voltage of the buffer circuit at a considerably lower level *in lieu of* the customary TTL-compatible level of 5 volts, so that also the occurring peak currents are considerably smaller as a result of the much smaller voltage swing in the output signal determined by the maximum drive of the first inverter circuit and, on the other hand, by defining a reference voltage level situated between the two extreme voltage levels of the buffer circuit output voltage, while the line carrying this reference voltage does not conduct signal currents and is therefore largely free from disturbing signals, so that there is avoided that the relatively low output voltage level is affected by disturbing signals.

The output of the buffer circuit, together with the reference voltage whose level in the case of a symmetrical supply voltage is preferably situated between the second and positive and negative supply voltage levels, can be transferred to another circuit, for example, another IC which is then capable of reconstructing from these two signals the input signal of the buffer circuit in the other circuit.

Therefore, the invention likewise relates to an input buffer circuit which is capable of performing this operation, this buffer circuit comprising a third inverter circuit with an input terminal and an output terminal which also form the input and output terminals of the buffer circuit, and with terminals for the second supply voltage and which is characterised, in that the third inverter circuit amplifies the signal received on the input terminal, by a second input terminal for receiving the reference voltage level and by reducing means for reducing the offset voltage of the buffer circuit and in that the third inverter circuit comprises at least a complementary pair of field effect transistors, whose respective gate and drain connections are mutually coupled, in which the input terminal is coupled to the mutually coupled gate connections and the output terminal is coupled to the mutually coupled drain connections, in which the source connection of the p-channel FET of the complementary pair is coupled to the terminal for the second positive supply voltage and the source connection of the n-channel FET of the pair is coupled to the terminal for the second negative supply voltage.

In the input buffer circuit the complementary pair of FET's restores the input voltage up to the original voltage level having a 5-volt swing, the reducing means for reducing the offset voltage preferably comprising a further pair of complementary FET's, each one of these FET's having its gate and drain connections coupled and these mutually coupled connections of the two FET's being coupled to the second input terminal and the source connections of the two FET's being coupled to the source connection of the corresponding FET of the complementary pair. This measure limits the offset voltage of the input buffer circuit.

For predetermining the voltage which the inverter and the capacitor directly transfer to the output of the output buffer circuit, so that it does not exceed the output voltage of the buffer circuit itself which is undesired because it leads to signal distortion of the output signal in the form of overshoot, preferably between the output terminal of the output buffer circuit and a common voltage level (earth) and between the input terminal of the input buffer circuit and this common voltage level, preferably a second and a third capacitor respectively, are provided which, in combination with the first capacitor, constitute a capacitive voltage divider for reducing the input voltage swing of the output buffer circuit to a maximum of the output voltage swing thereof.

It should further be observed that from US-A-4,002,928 a system is known comprising an output buffer circuit and an input buffer circuit, which buffer circuits are present, for example, on the output side of an integrated circuit and the input side of another integrated circuit respectively, in which system the pulse-shaped signal to be transmitted is brought to a lower voltage level so as to increase the transmission rate in the output buffer circuit and is brought back to the original voltage level upon reception in the input buffer circuit. However, this known system does not comprise a separate reference voltage line, so that the signals are related to the voltage level on one of the supply voltage lines which may carry, even with lower signal levels, considerable disturbing signals due to the high supply currents during voltage transitions. Neither does the system according to the above United Stated Patent comprise means for improving the edge steepness of the signal to be transmitted.

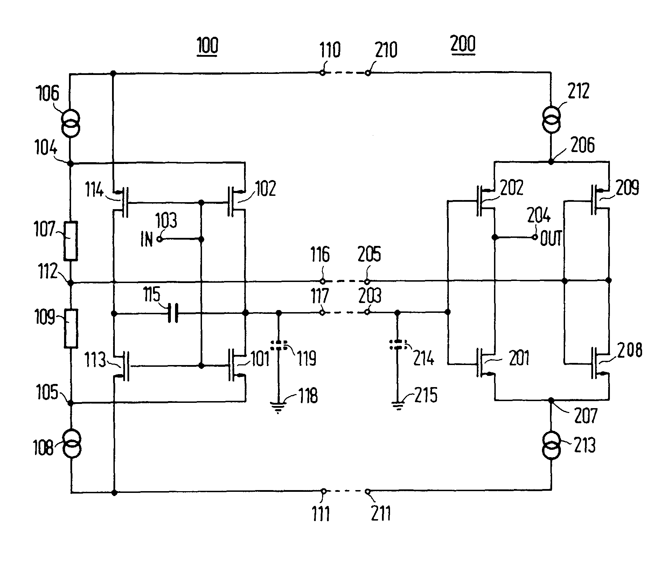

The invention will be further explained hereinafter with the aid of an exemplary embodiment with reference to the drawing in which the sole Figure shows a diagram of a system comprising an output buffer circuit and a input buffer circuit according to the invention.

In the drawing Figure is shown in general an output buffer circuit denoted by reference numeral 100 and an input buffer circuit denoted by reference numeral 200 according to the invention. The two buffer circuits may be present, for example, in two separate integrated circuits, between which pulse-shaped (logic) signals are to be transmitted. Such integrated circuits (ICs) may, for example, form part of an echo canceller for telephony purposes in which one IC comprises the analog interface to the telephone line and the other IC the digital circuit for the signal processing. A clock signal having a frequency of, for example, 7.68 MHz, a sign signal having a frequency of, for example, 80 kHZ, as well as the output signal of an analog-to-digital converter, for example, a sigma delta modulator, are then transmitted between such ICs. For each of the types of signal to be transmitted one IC could then comprise a output buffer circuit according to the invention and the other IC an input buffer circuit according to the invention. The buffer circuits according to the invention, however, may also be applied to many other types of circuits than those used for telephony.

The output buffer circuit 100 comprises a first inverter circuit preferably formed by an n-channel C-MOSFET 101 and a p-channel C-MOSFET 102, together forming a complementary pair, in which the gate and drain connections respectively, of the FET's are mutually coupled. An input terminal 103 of the output buffer circuit is coupled to the mutually coupled gate connections and an output terminal 117 is coupled to the mutually coupled drain connections. The source connection of the FET 102 is coupled to a junction 104 for a first positive supply voltage and the source connection of the FET 101 is coupled to a junction 105 for a first negative supply voltage.

The voltage level at the junctions 104 and 105 determines the maximum voltage swing of the output buffer circuit output voltage on terminal 117 and this swing, according to the exemplary embodiment, is ten times smaller than the swing of the voltage applied to the input 103. When the input voltage has the TTL compatible voltage swing of 5 volts, the output voltage thus has a voltage swing of 0.5 volt which means that the supply voltage on the respective terminals 104 and 105 is to be +250 mV and -250 mV for the first inverter circuit. The positive voltage level is determined in a manner known *per se* by means of a series combination of a current source 106 and a resistor 107 which combination is inserted between the terminal 110 for a second positive supply voltage of, for example, +2.5 volts, and a reference voltage line 112. The voltage level of +250 mV is then available at the junction between the current source 106 and the resistor 107 when the current supplied by the current source and the magnitude of the resistor are properly chosen. In like manner the negative first supply voltage at junction 105 is determined by a current source 108 and a resistor 109, the current source 108 being connected to a terminal 111 for a second negative supply voltage of, for example, -2.5 volts. If the absolute values of the voltage levels at the junctions 104 and 105 are equally large and the magnitudes of the resistors 107 and 109 are equally large, the voltage level on line 112 is equal to 0 volts. By means of an inverter circuit structured in this manner an input voltage having a swing of 5 volts is converted into an inverted output voltage having a swing of 250 mV, which generates considerably smaller peak currents on the supply voltage lines 110 and 112, and thus a considerably lower interference level. According to a further aspect of the invention, however, the voltage level on the output terminal 117 is not related, as is customary in the state of the art, to one of the supply voltage levels on the line 110 or 111 and neither is it related to the voltage level on the terminal 118 for the common voltage level (earth), in order to prevent that the, though low, but still present disturbing signals on these lines detrimentally affect the now relatively low output voltage level. According to the invention the output voltage is related to the reference voltage level on line 112 through which line no signal currents flow any longer, so that this reference voltage is very "pure".

Since inverter circuits comprising C-MOSFET's are relatively slow and are incapable of providing a output voltage with a very high edge steepness, the buffer circuit 100 comprises a second inverter circuit, preferably also constituted by C-MOSFET's, *i. e*. an n-channel C-MOSFET 113 and a p-channel C-MOSFET 114, together forming a complementary pair in which the gate and drain connections of the FET's are mutually coupled. The source connections of the FET's 113 and 114 are connected to the second negative supply voltage level of -2.5 volts on line 111 and the second positive supply voltage level of +2.5 volts on line 110 respectively. The mutually coupled gate connections are connected to the input terminal 103 and the mutually coupled drain connections are connected to the output terminal 117 by way of a capacitor 115. With this combination of an inverter circuit and a capacitor, input voltage variations may be transferred rapidly to the output so as to enhance the edge steepness of the output voltage. For a more detailed discussion of the operation of such a circuit reference be made to DE-A-2929450. It is undesired for the inverter circuit comprising the FET's 113 and 114 to transfer the complete voltage swing of 5 volts to the output 117 by way of the capacitor 115, because this may lead to overshoot in the output signal. Therefore, a second capacitor 119 is provided which is connected to the output terminal 117 and to the common voltage level at point 118 and which, together with the capacitor 115, forms a capacitive voltage divider limiting the voltage swing on output 117.

The output buffer circuit 200 comprises voltage supply terminals 215, 210 and 211 which carry the same supply voltage levels as the respective lines 118, 110 and 111 in the output buffer circuit 100 and which, according to the embodiment, thus carry the common voltage levels (earth) of +2.5 volts and -2.5 volts respectively. The input buffer circuit 200 further includes an inverter circuit comprising an n-channel C-MOSFET 201 and a p-channel C-MOSFET 202 which together form a complementary pair in which the gate and drain connections of the FET's are mutually coupled. The input terminal 203 of the input buffer circuit is coupled to the mutually coupled gate connections and an output terminal 204 is coupled to the mutually coupled drain connections. The source connection of the FET 202 is coupled to a terminal 206 of a current source 212 which is supplied from the positive supply voltage line 210 and the source connection of the FET 201 is coupled to a terminal 207 of a current source 213 which is supplied from the negative supply voltage line 211. The FET's 201 and 202 may thus reconvert an input voltage having a 0.5-volt swing received from the output terminal 117 of the output buffer circuit 100 into an inverted output voltage having a 5-volt swing on the output terminal 204, so that the signal on the input 103 of circuit 100 is again available with the right polarity and voltage swing at the output 204 of circuit 200. In order to limit the offset voltage of the input buffer circuit 200, there are provided a n-channel C-MOSFET 208 and a p-channel C-MOSFET 209 which together form a complementary pair in which the gate and drain connections of these two FET's 210 and 209 are mutually coupled and are also connected to a terminal 205 for receiving the reference voltage level from terminal 116 of the circuit 100. The source connection of the n-channel C-MOSFET 208 is also connected to the terminal 207 of the current source 213 and the source connection of the p-channel C-MOSFET 209 is connected to the terminal 206 of the current source 212. Since the gate/drain voltage of the two FET's 208 and 209 has thus been made equal to 0 volts and by giving, on one hand, the n-channel FET's 201 and 208 and, on the other hand, the p-channel FET's 202 and 209 largely identical features, the offset voltage may be reduced to a negligibly small level.

Between the input terminal 203 of the circuit 200 and the common supply line 215, a capacitor 214 is inserted which, in combination with the capacitor 119 of circuit 100, determines the divisor of the capacitive voltage divider. When the values of the capacitors 119 and 214 are computed, the magnitude of the already available (parasitic) output capacitance or input capacitance respectively, of the circuits 100 and 200 may be taken into account.

## Claims

1. An output buffer circuit comprising a first inverter circuit with an input terminal and an output terminal which also form the input terminal and the output terminal of the buffer circuit, and with terminals for a first supply voltage, there being inserted between the input terminal and the output terminal of the buffer circuit a series combination of a second inverter circuit and a first capacitor which second inverter circuit is connected to terminals for a second supply voltage, characterised in that the voltage swing of the output signal on the output terminal of the buffer circuit is a predetermined fraction of the voltage swing of the signal applied to the input terminal and in that determining means are provided for determining a reference voltage level as a further output signal, said determining means receiving the first supply voltage.

2. Buffer circuit as claimed in Claim 1, in which the first and second supply voltages are symmetrical supply voltages, characterised in that the first inverter circuit comprises at least a complementary pair of field effect transistors whose gate and drain connections respectively, are mutually coupled, in which the input terminal is coupled to the mutually coupled gate connections and the output terminal is coupled to the mutually coupled drain connections, in which the source connection of the p-channel FET of the complementary pair is coupled to the terminal for the first positive supply voltage and the source connection of the n-channel FET of the pair is coupled to the terminal for the first negative supply voltage and in that the reference voltage level is situated between the positive and the negative second voltage level.

3. Buffer circuit for a buffer circuit as claimed in Claim 1 or 2 and comprising a third inverter circuit with an input terminal and an output terminal which also form the input and output terminals of the buffer circuit, and coupled to terminals for the second supply voltage, whereby the third inverter comprises a CMOS inverter and presents on the output terminal an enlarged version of the voltage swing of the signal received on the input terminal, and whereby a second input terminal receives said reference voltage level and provides it to means for reducing the offset voltage of the buffer circuit, said reducing means being connected between the power supply terminals of said third inverter.

4. Buffer circuit as claimed in Claim 3, characterised in that the reducing means for reducing the offset voltage of the buffer circuit comprises a further pair of complementary FET's, in which each one of these FET's has its gate and drain connections mutually coupled and these mutually coupled connections of the two FET's are coupled to the second input terminal and in which the source connections of the two FET's are coupled to the source connection of the corresponding FET of the complementary pair.

5. Buffer circuit as claimed in one of the Claims 3 or 4, characterised in that the voltage swing of the signal on the output terminal is the same as that of the signal on the output terminal of the output buffer circuit.

6. System comprising a buffer circuit operating as an output buffer circuit as claimed in Claim 1 or 2, whose output is coupled to the input of a buffer circuit operating as an input buffer circuit as claimed in Claim 3, 4 or 5, characterised in that between the output terminal of the output buffer circuit and a common voltage level and between the input terminal of the input buffer circuit and this common voltage level a second and a third capacitor respectively, are provided which, in combination with the first capacitor, constitute a capacitive voltage divider.

7. Buffer circuit as claimed in one of the Claims 1 to 4, characterised in that all the FET's are arranged as C-MOSFET's.

8. Buffer circuit as claimed in one of the Claims 1 to 4, characterized in that the first supply voltage level is +250 mV and -250 mV respectively, and in that the second supply voltage level is +5 volts and -5 volts respectively.

## Patentansprüche

1. Ausgangspufferschaltung, die mit einer ersten Inverterschaltung, mit einer Eingangsklemme und einer Ausgangsklemme, die auch die Eingangs- bzw. Ausgangsklemme der Pufferschaltung bilden, und mit Anschlußklemmen für eine erste Speise-spannung versehen ist, wobei zwischen der Eingangsklemme und der Ausgangsklemme der Pufferschaltung eine Reihenschaltung aus einer zweiten Inverterschaltung und einem ersten Kondensator vorgesehen ist, wobei diese zweite Inverterschaltung mit Anschlußklemmen für eine zweite Speisespannung verbunden ist, dadurch gekennzeichnet, daß der Spannungshub des Ausgangssignals an der Ausgangsklemme der Pufferschaltung ein vorbestimmter Bruchteil des Spannungshubes des der Eingangsklemme angebotenen Signals ist und daß Mittel vorgesehen sind um einen Bezugsspannungspegel als ein weiteres Ausgangssignal festzulegen, wobei diese Mittel die erste Speisespannung zugeführt bekommen.

2. Pufferschaltung nach Anspruch 1, die erste und die zweite Speisespannung symmetrische Speisespannungen sind, dadurch gekennzeichnet, daß die erste Inverterschaltung wenigstens ein komplementäres Paar von Feldeffekttransistoren umfaßt, deren Gate- und Drain-Anschlüsse miteinander gekoppelt sind, wobei die Eingangsklemme mit den miteinander gekoppelten Gate-Anschlüssen gekoppelt ist und die Ausgangsklemme mit den miteinander gekoppelten Drain-Anschlüssen gekoppelt ist, wobei der Source-Anschluß des p-leitenden FETs des komplementären Paares mit der Anschlußklemme für die erste positive Speisespannung und der Source-Anschluß des n-leitenden FETs des Paares mit der Anschlußklemme für die erste negative Speisespannung gekoppelt ist und daß der Bezugsspannungspegel zwischen dem positiven und dem negativen zweiten Spannungspegel liegt.

3. Pufferschaltung nach Anspruch 1 oder 2, mit einer dritten Inverterschaltung mit einer Eingangsklemme und einer Ausgangsklemme, die auch die Eingangs- bzw. Ausgangsklemme der Pufferschaltung bilden, und mit Anschlußklemmen für die zweite Speisespannung, wobei die dritte Inverterschaltung einen CMOS-Inverter aufweistund an der Ausgangsklemme eine verstärkte Version des Spannungshubes des an der Eingangsklemme empfangenen Signals aufweist und wobei eine zweite Eingangsklemme den genannten Bezugsspannungspegel erhält und diesen Mitteln zuführt zur Verringerung der Offsetspannung der Pufferschaltung, wobei diese Reduziermittel zwischen den Speiseklemmen des genannten dritten Inverters vorgesehen sind.

4. Pufferschaltung nach Anspruch 3, dadurch gekennzeichnet, daß die Mittel zum Verringern der Offset-Spannung der Pufferschaltung ein weiteres Paar komplementärer FETen aufweisen, wobei von jedem dieser FETen die Gate-Elektrode und die Drain-Elektrode miteinander verbunden sind und diese miteinander verbundenen Anschlüsse der beiden FETen mit der zweiten Einmgangsklemme gekoppelt sind und wobei die Source-Elektroden der beiden FETen mit der Source-Verbindung des betreffenden FETs des komplementären Paares gekoppelt ist.

5. Pufferschaltung nach Anspruch 3 oder 4, dadurch gekennzeichnet, daß der Spannungshub des Signals an der Ausgangsklemme derselbe ist wie der des Signals an der Ausgangsklemme der Ausgangspufferschaltung.

6. System mit einer Pufferschaltung, die als Ausgangspufferschaltung nach Anspruch 1 oder 2 funktioniert, wobei der Ausgang mit dem Eingang einer Pufferschaltung gekoppelt ist, die als Eingangspufferschaltung nach Anspruch 3, 4 oder 5 funktioniert, dadurch gekennzeichnet, daß zwischen der Ausgangsklemme der Ausgangspufferschaltung und einem gemeinsamen Spannungspegel und zwischen der Eingangsklemme der Eingangspufferschaltung und diesem gemeinsamen Spannungs-pegel ein zweiter bzw. ein dritter Kondensator vorgesehen sind, die in Kombination mit dem ersten Kondensator einen kapazitiven Spannungsteiler bilden.

7. Pufferschaltung nach einem der Ansprüche 1 bis 4, dadurch gekennzeichnet, daß alle FETen als C-MOSFETen ausgebildet sind.

8. Pufferschaltung nach einem der Ansprüche 1 bis 4, dadurch gekennzeichnet, daß der erste Speisespannungspegel +250 mV bzw. -250 mV beträgt und daß der zweite Speisespannungspegel +5 Volt bzw. - 5 Volt beträgt.

## Revendications

1. Circuit tampon de sortie comprenant un premier circuit inverseur avec une borne d'entrée et une borne de sortie, qui constituent également la borne d'entrée et la borne de sortie du circuit tampon, et avec des bornes pour une première tension d'alimentation, un montage en série d'un deuxième circuit inverseur et d'un premier condensateur étant inséré entre la borne d'entrée et la borne de sortie du circuit tampon, lequel deuxième circuit inverseur est connecté à des bornes pour une deuxième tension d'alimentation, caractérisé en ce que l'amplitude crête-crête de tension du signal de sortie à la borne de sortie du circuit tampon est une fraction prédéterminée de l'amplitude crête-crête du signal appliqué à la borne d'entrée, et en ce que des moyens de détermination sont prévus pour déterminer un niveau de tension de référence comme signal de sortie supplémentaire, lesdits moyens de détermination recevant la première tension d'alimentation.

2. Circuit tampon suivant la revendication 1, dans lequel les première et deuxième tensions d'alimentation sont des tensions d'alimentation symétriques, caractérisé en ce que le premier circuit inverseur comprend au moins une paire complémentaire de transistors à effet de champ dont respectivement les connexions de grille et de drain sont mutuellement couplées, dans laquelle la borne d'entrée est couplée aux connexions de grille mutuellement couplées et la borne de sortie est couplée aux connexions de drain mutuellement couplées, dans laquelle la connexion de source du FET à canal p de la paire complémentaire est couplée à la borne pour la première tension d'alimentation positive et la connexion de source du FET à canal n de la paire est couplée à la borne pour la première tension d'alimentation négative, et en ce que le niveau de tension de référence se situe entre les deuxièmes niveaux positif et négatif de tension.

3. Circuit tampon pour un circuit tampon suivant la revendication 1 ou 2 et comprenant un troisième circuit inverseur avec une borne d'entrée et une borne de sortie, qui constituent également les bornes d'entrée et de sortie du circuit tampon, et couplées à des bornes pour la deuxième tension d'alimentation, le troisième circuit inverseur comprenant un inverseur CMOS et présentant à la borne de sortie une version agrandie de l'amplitude crête-crête de tension du signal reçu à la borne d'entrée, et une deuxième borne d'entrée recevant ledit niveau de tension de référence et le fournissant à des moyens destinés à réduire la tension de décalage du circuit tampon, ledit moyen de réduction étant connecté entre les bornes d'alimentation dudit troisième inverseur.

4. Circuit tampon suivant la revendication 3, caractérisé en ce que le moyen de réduction destiné à réduire la tension de décalage du circuit tampon comprend une autre paire de FET complémentaires, dans laquelle chacun de ces FET a ses connexions de grille et de drain mutuellement couplées et ces connexions mutuellement couplées des deux FET sont couplées à la deuxième borne d'entrée et dans laquelle les connexions de source des deux FET sont couplées à la connexion de source du FET correspondant de la paire complémentaire.

5. Circuit tampon suivant la revendication 3 ou 4, caractérisé en ce que l'amplitude crête-crête de tension du signal à la borne de sortie est la même que celle du signal à la borne de sortie du circuit tampon de sortie.

6. Système comprenant un circuit tampon fonctionnant comme circuit tampon de sortie suivant la revendication 1 ou 2, dont la sortie est couplée à l'entrée d'un circuit tampon fonctionnant comme circuit tampon d'entrée suivant la revendication 3, 4 ou 5, caractérisé en ce que, entre la borne de sortie du circuit tampon de sortie et un niveau commun de tension et entre la borne d'entrée du circuit tampon d'entrée et ce niveau commun de tension, respectivement un deuxième et un troisième condensateurs sont fournis, qui, en combinaison avec le premier condensateur, constituent un diviseur de tension capacitif.

7. Circuit tampon suivant l'une quelconque des revendications 1 à 4, caractérisé en ce que tous les FET sont agencés comme des C-MOSFET.

8. Circuit tampon suivant l'une quelconque des revendications 1 à 4, caractérisé en ce que les premiers niveaux de tension d'alimentation sont respectivement de +250 mV et -250 mV et en ce que les deuxièmes niveaux de tension d'alimentation sont respectivement de +5 volts et -5 volts.
